# EUROPEAN PATENT SPECIFICATION

(11) **EP 4 168 834 B1**
(45) Date of publication and mention of the grant of the patent: **11.03.2026**
(21) Application number: 21824996.9
(22) Date of filing: 09.06.2021
(51) Int. Cl.: G02B 5/18, G02B 27/01, G02B 6/00, C23C 14/04, C23C 16/04, C23C 14/58, C23C 16/56

(54) **MANUFACTURING METHOD OF OPTICAL ELEMENT, OPTICAL ELEMENT AND APPARATUS FOR MANUFACTURING OPTICAL ELEMENT**
HERSTELLUNGSVERFAHREN FÜR EIN OPTISCHES ELEMENT, OPTISCHES ELEMENT UND VORRICHTUNG ZUR HERSTELLUNG EINES OPTISCHEN ELEMENTS
PROCÉDÉ DE FABRICATION D'UN ÉLÉMENT OPTIQUE, ÉLÉMENT OPTIQUE ET APPAREIL DE FABRICATION D'ÉLÉMENT OPTIQUE

(30) Priority: 17.06.2020 FI 20205642
(43) Date of publication of application: 26.04.2023
(73) Proprietor: Dispelix Oy, 02130 Espoo (FI)
(72) Inventor: ERDMANIS, Mikhail, 02130 Espoo (FI)
(74) Representative: Schüssler, Andrea
(86) International application number: PCT/FI2021/050428
(87) International publication number: WO 2021/255332

(56) References cited:
- WO-A1-2020/018270
- WO-A1-2020/018270
- CN-A- 109 839 746
- CN-A- 109 839 746
- CN-A- 110 806 645
- CN-A- 110 806 645
- US-A- 5 784 507
- US-A- 5 784 507
- US-A1- 2016 062 037
- US-A1- 2016 062 037
- US-A1- 2018 374 423
- US-A1- 2018 374 423
- US-A1- 2019 056 591
- US-A1- 2019 056 591
- US-A1- 2020 110 278
- US-A1- 2020 110 278

## Description

### Field

The invention relates to a manufacturing method of an optical element, the optical element and an apparatus for manufacturing it the optical element.

### Background

US 2020/0110278 A1 concerns a method and system for tunable gradient patterning using a shadow mask.

WO 2020/018270 A1 concerns an apparatus with a grating structure and a method for forming the same. The grating structure includes forming a recess in a grating layer. A plurality of channels is formed in the grating layer to define slanted grating structures therein. The recess and the slanted grating structures are formed using a selective etch process.

US 2016/0062037 A1 concerns a semiconductor device and method for manufacturing the same.

An optical combiner of an augmented reality (AR) eyewear based on a diffractive grating is often fabricated with a high refractive index films that are deposited on top of a transparent substrate serving as a lightguide, and patterned in order to form a diffractive optical element (DOE).

The operation of the eyewear implies that light of a visible range is coupled into a waveguide through a diffractive grating and, after the light being distributed inside the waveguide, it is out-coupled through another diffractive grating such that a user sees a digital image in addition to surrounding environment that can be seen through the waveguide. In order to achieve better image quality, scattering strength of the diffractive grating arrangement often should be modulated in a controllable fashion between low and high values with large differences in scattering intensity across the diffractive grating arrangement, e.g. by a factor of 2 to10 or more.

There are standard ways to modulate scattering strength across the diffractive grating arrangement including either a variation in grating pattern itself or a change in height of grating features (i.e. grating ridge height or grating groove depth). The variations of grating pattern are inherently limited by utilized fabrication processes and often they cannot provide strong enough modulation in scattering intensity across the diffractive grating arrangement (e.g. by a factor of 10 or more). Consequently, in many cases there is a need for controllable variation in height of the grating features. However, this type of modulation makes the fabrication of diffractive grating arrangements more complex and requires the use of additional process steps such as: deposition of additional layers, introduction of multiple etching steps, use of grayscale lithography, etc. Also, in such complex fabrication sequences, process yield suffers and fabrication costs increase. Hence, there is a fundamental necessity for improvement.

### Brief description

The present invention seeks to provide an improvement in manufacturability of the AR eyewear.

The invention is defined by the independent claims. Embodiments are defined in the dependent claims.

### List of drawings

Example embodiments of the present invention are described below, by way of example only, with reference to the accompanying drawings, in which
Figures 1A and 1B illustrate examples of an AR eyewear;
Figure 2 illustrates an example of a deposition process;
Figure 3A illustrates an example of a plate with perforations;
Figure 3B illustrates an example of a layer of solid material deposited onto a waveguide through the plate having perforations;
Figure 3C illustrates an example of a patterned resist or etching mask on the layer;
Figure 4 illustrates an example of a distribution of heights of ridges of a diffraction grating, ridges being made of the solid material on a waveguide;
Figure 5A illustrates an example of distributions of heights of ridges made of a solid material and a cross-sectional areas of perforations of a plate;
Figure 5B illustrates another example of distributions of heights of the ridges and the cross-sectional areas of perforations of a plate;
Figure 6 illustrates an example of a curvy plate;
Figure 7 illustrates an example of a DOE which comprises a waveguide with diffraction gratings; and
Figure 8 illustrates of an example of a flow chart of a manufacturing method.

### Description of embodiments

The following embodiments are only examples. Although the specification may refer to "an" embodiment in several locations, this does not necessarily mean that each such a reference is to the same embodiment(s), or that the feature only applies to a single embodiment. Single features of different embodiments may also be combined to provide other embodiments. Furthermore, words "comprising" and "including" should be understood as not limiting the described embodiments to consist of only those features that have been mentioned and such embodiments may also contain features/structures that have not been specifically mentioned. All combinations of the embodiments are considered possible if their combination does not lead to structural or logical contradiction.

It should be noted that while Figures illustrate various embodiments, they are simplified diagrams that only show some structures and/or functional entities. The connections shown in the Figures may refer to logical or physical connections. It is apparent to a person skilled in the art that the described apparatus may also comprise other functions and structures than those described in Figures and text. It should be appreciated that details of some functions, structures, and the signalling used for operation are irrelevant to the actual invention. Therefore, they need not be discussed in more detail here.

Below, a technique to control a local thickness of features of diffraction grating(s) made of a solid material, which has a high refractive index, is presented. The features, which are periodical, may include ridges and grooves of the diffraction grating(s), for example, an groove locating between any two directly adjacent ridges and vice versa. The thickness can be controlled in one or two dimensions. A fundamental benefit of such an approach is that a thickness profile of the features of the solid material with a high refractive index can be custom-shaped. The formed profiles are then used for the fabrication of DOE with scattering efficiency modulation following the deposited film thickness profiles. The DOEs can be then formed with only one etching step, for example, unlike in approaches with multiple etching steps.

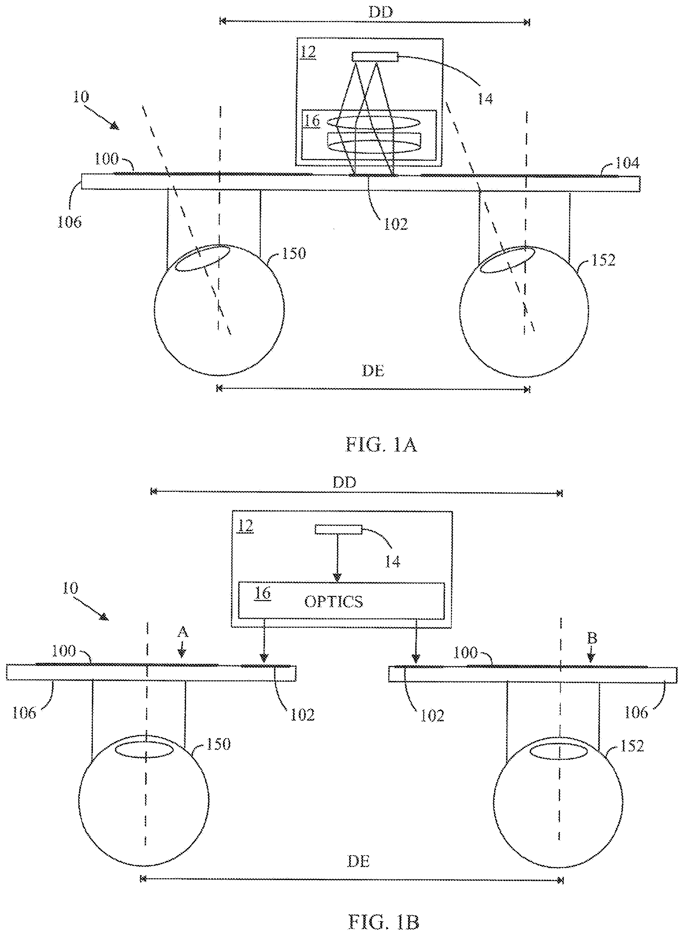

Figures 1A and 1B illustrate examples of an AR (Augmented Reality) eyewear. The eyewear may look like glasses, spectacles or goggles, for example. In an embodiment, the eyewear may be in connection with a headwear like a cap, a hat or a helmet, for example. In Figure 1A, the eyewear comprises an optical element 10 and an image generating unit 12, which in turn may have an image source 14 and an optic component arrangement 16. The image generating unit 12 generates visible light of an image (still or video) that is coupled to a waveguide 106 of visible light through the optic component arrangement 16 and a diffractive grating 102, which is on a surface of the waveguide 106. In Figure 1B, the eye wear comprises two parts A and B, each for one eye 150, 152. The image generating unit 12 may direct the visible light of the image to the optic component arrangement 16, which may split the light for the two parts A and B. Instead of optical splitting, the eyewear may have two image generating units 12, each for one part A and B.

The waveguide 106 allows visible light to propagate via total internal reflection from an in-coupling area, where the visible light is in-coupled by a diffractive grating 102 into the waveguide 106, to one or more desired areas, which have a first out-coupling diffractive element 100 and a second out-coupling diffractive grating 104. The waveguide 106 may be made up of a transparent material like glass, sapphire and/or a polymer, for example. The glass may comprise a high refractive index flint glass family, for example. The waveguide 106 may also be called lightguide. A refractive index of the waveguide 106 may be from about 1.7 to 2 or higher.

The visible light is thus guided laterally within the waveguide 106, and one or two of the first and second out-coupling diffractive gratings 100, 104 couple the visible light out of the waveguide 106 in order direct the visible light into one or two eyes 150, 152 of a user for showing the image. The out-coupling diffractive gratings 100, 104 are used as optical combiners in the AR eyewear. The user may namely see the environment through the optical component 10 and the image scattered from the first and second diffractive gratings 100, 104.

In an embodiment, a distance DD between a first out-coupling diffractive grating 100 and a second out-coupling diffractive grating 104 may be at least approximately the same as a distance DE between eyes 150, 152 of a human being that is referred to as an interpupillary distance (IPD). The distance DD may be about 63 mm, for example. However, the first out-coupling diffractive grating 100, the in-coupling diffractive grating 102 and the second out-coupling diffractive grating 104 may form a continuous diffractive element structure on the waveguide 106 in another embodiment.

As a further detail, the distance DD may be the same as an average or an estimate of the IPD, for example. The IPD i.e. the distance DE may be about 64 mm for a male and 62 mm for female, for example. Hence, the distance DD may be determined as a spacing between a center of the first out-coupling diffractive grating 100 and a center of the second out-coupling diffractive grating 104.

In an embodiment an example of which is illustrated in Figure 1A, the eyewear has one optical component 10 and one image generating unit 12 for both eyes 150, 152.

In an embodiment, the eyewear may have one optical component 10 and one image generating unit 12 per one eye 150, 152.

The diffractive gratings 100 to 104 may be on either side of the waveguide 106 in an embodiment. In an embodiment, at least one of the diffractive gratings 100 to 104 may be on a side of the waveguide 106 opposite to at least one other of them.

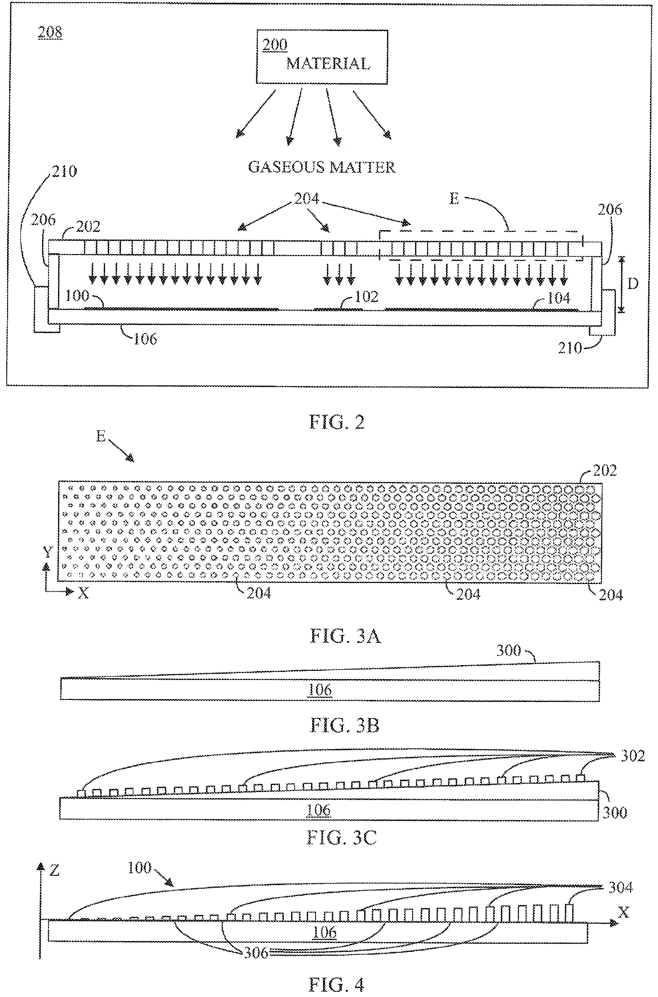

Figure 2 illustrates an example of a deposition process. Material 200 used to form at least one diffractive grating 100, 102, 104 is deposited onto the waveguide 106 or a preform of the waveguide 106 through perforations 204 of a plate 202. During a manufacturing process, the term "waveguide" is also considered to include the preform of the waveguide 106. The plate 202 is at a non-zero distance D from the waveguide 106. The distance D may be set using a spacer structure 206, for example. The plate 202 may be supported by the spacer structure 206. If a shape of the waveguide 106 is a circle, the spacer structure 206 may be a ring that is around an outer contour of the waveguide 106. A total thickness of the structure including the spacer structure 206 may have a thickness larger than the distance D. The spacer structure 206 may have a shape with a circular outer circumference and an inner side with a circular opening, rectangular opening(s) and/or other custom-shaped openings that support positioning of the plate above the waveguide 106 and screen other areas from getting material 200 deposited thereon. Hence, the spacer structure 206 may have a thickness equal to the distance D. A material of the spacer structure 206 may comprise metal, glass, ceramic or the like for example. In an embodiment, the spacer structure 206 may comprise anodized aluminum, for example.

In an embodiment, the spacer structure 206 may comprise at least one adjustment arrangement 210. The adjustment arrangement 210 may be mechanical, electro-mechanical, hydraulic and/or pneumatic, for example. A mechanical adjustment arrangement may comprise a screw, for example. An electro-mechanical adjustment arrangement may comprise an electric motor and a screw that is rotated by the electric motor, for example.

The distance D is an important parameter that may be taken into account depending on the following: a) type of deposition reactor, nature and parameters of deposition process; b) thickness of the plate 202; c) feature size including height and/or width of the perforations 204 and structure of the perforations 204 in the plate 202; d) particular DOE layout; e) arrangement of DOEs on a wafer. Here the DOE layout means that different grating shapes are possible and depending on the particular shape (e.g., rectangular, bowtie, triangle, etc.) the perforations 204 in the plate 202 would have different arrangement. Arrangement of the DOEs implies that there are different options depending on how e.g. several DOE with varying heights are positioned with respect to each other in order to adjust or control the height profile of the layer 300.

The distance D between the plate 202 and the waveguide 106 may be set to a specific optimal value. In an embodiment, the distance D may be about 5mm, for example. If the distance D is too small, features of the perforations 204 may not even out sufficiently and the structure of a layer 300 may fail to be conformal enough. If the distance D is too long, an accuracy of a local film thickness control may degrade. In an embodiment, the plate 202 may be tilted with respect to the waveguide 106.

In an embodiment, the spacer structure 206 may also include additional elements that are case-specific and are not shown in the drawings. These elements may be: a) additional features supporting a shadow mask, b) additional features used to screen the areas of fabricated DOE (or around DOE) where high refractive materials should not be deposited, i.e. the areas that should stay clean from the deposited high refractive index layer.

The material of the plate 202 may comprise metal, glass, ceramic or the like, for example. In an embodiment, the metal may be stainless steel that may be of a high purity, for example. In an embodiment, a thickness of the plate 202 may be between about 0.001 mm to about 1 mm, for example. In an embodiment, a typical thickness may be about 0.01 mm to about 0.1 mm, for example. In an example, the thickness may be about 0.05mm.

In an embodiment, a diameter of the waveguide 106 and the plate 202 may vary from tens of millimeters to 450 mm, for example. A large waveguide 106 may be cut into pieces that are suitable for the eyewear. In an embodiment, a diameter of the waveguide 106 and the plate 202 may be about 100mm, for example. The deposition system 208 may be scaled/modified or scalable for waveguides 106 of smaller/larger diameter.

As shown in an example of Figure 3A, which shows a section E of Figure 2, a cross sectional area of the perforations 204 vary in a determined manner depending on a location in the plate 202 (only a few of the perforations have reference number in Figure 3A because all the perforations cannot be marked with numbers). In the example of Figure 3A, the cross sectional area of the perforations 204 varies in the direction of X-axis but keeps constant in the direction of Y-axis.

In an embodiment, the variation of the cross sectional areas of the perforations 204 may be one dimensional over a surface of the plate 202 while the cross sectional areas of the perforations 204 may remain constant in another dimension (the perforations can be distributed spatially only in two dimensions). The dimensions, each of which can be considered a spatial extent orthogonal to and/or independent from another dimension, may be those of a Cartesian coordinate system or a polar coordinate system. In an embodiment, the cross sectional areas of the perforations 204 may vary as a function of values of both dimensions.

Figure 3A shows hexagon-type perforation as an example, and modulation of mask opening areas in the X-direction. Shapes of the perforations 204 may be: hexagonal, circular, rectangular, linear, star, any combination of these, for example. The shapes of the perforations 204 may also be custom-made.

The plate 202 with the perforations 204 can be made to fulfil a desired opening-to-solid area ratio or a grating fill factor in the x-direction, the x- and y-directions, or custom patterns across the plate 202.

In an embodiment, the solid material 200 may be turned into a flowable state, which may be a gaseous state or a vapor state, in order to allow its passing through the perforations 204 of the plate 202. Then the material 200 in the flowable state solidifies on the waveguide 106.

In an embodiment, the material transfer for deposition onto a waveguide may be performed in a vaporized state, for example. Then the solid material 200 may be turned into a vapor state and the vapor is condensed as layered or film structure on the waveguide 106 in a vapor deposition process, for example. The vapor deposition may be realized using sputtering, chemical vapor deposition or physical vapor deposition, for example, without limiting to these.

A person skilled in the art is familiar with various deposition systems and processes that can be used as the deposition system 208.The solid material 200 may have a refractive index equal to or higher than that of the waveguide 106 in the visible range of light, for example. The refractive index of the material 200 may in some cases be also lower than that of the waveguide 106. A refractive index of the solid material 200 may be in a range about 1.8 to about 2.7 or even up to 3.5, for example. However, it may also be lower than about 1.8. A high refraction index results in an effective scattering of light, and typically better DOE performance over a wide range of in-coupling and out-coupling angles which in turn results in better image quality for a user.

Figure 3B shows an example of how a perforated pattern of the plate 202 may be transformed into a specific height profile of a layer 300 of material 200 on the waveguide 106. The distribution of the material 200 may be linear as in this example, or it may follow any shape such as that of a non-linear function.

The unit cell of features in the plate 202 should be small enough to provide high control of local thickness and good uniformity of the layer 300. As the minimum feature size is limited among other factors by a thickness of the plate 202 and a perforation technique, thin masks such as 0.1mm and below may be generally favorable. A required resolution of features of the plate 202 and a thickness of the plate 202 are dependent on the particular layout of the fabricated DOE.

In an embodiment, the distance D between the plate 202 and the waveguide 106 may depend on the areas of the cross sections of the perforations 204 of the plate 202. In an embodiment, the distance D between the plate 202 and the waveguide 106 may depend on the smallest areas of the cross sections of the perforations 204 of the plate 202.

In an embodiment, the distance D may be the shorter the smaller the area of the cross sections of the perforations 204 of the plate 202 is. Correspondingly, the distance D may be the longer the larger the area of the cross sections of the perforations 204 of the plate 202 is. In this manner, the material 200 may spread also to the areas of the waveguide 106 that are not directly overlapping or facing the perforations 204. Such a spread, in turn, results in a flat or at least fairly/reasonably flat layer 300 of the material 200 on the waveguide 106.

Figure 3C illustrates an example of a patterned resist or an etching mask layer 302 on the layer 300 of material 200. The layer 300 of material 200 may then be etched in order to form features including ridges 304 and grooves 306 of a grating (see Figure 4). In an embodiment, the etching may include dry etching. Instead of etching, the features of the diffraction grating (100 to 104) may be formed by any other suitable prior art patterning method, for example.

As shown in an example of Figure 4, the at least one diffractive grating 100 to 104 is thus made of the layer 300 of the solid material 200, which is transferred to the waveguide 106 in the deposition system 208. A material removal device, which may as explained above include etching device or any other suitable prior art material removal device, may remove the solid material 200 of the layer 300 from locations of grooves 306 of the at least one diffractive grating 100 to 104 and keep the solid material 200 of the layer 300 at locations of the ridges 304 of the at least one diffractive grating 100 to 104. The horizontal axis X denotes a location in one direction and the vertical axis denotes a height H. Both axes are in an arbitrary scale.

An amount of the solid material 200 of each of the ridges 304 of a grating 100 to 104 on the waveguide 106 varies in response to the cross sectional area of the perforations 204. Because of that, a height of each of the ridges 304 made of the solid material 200 on the waveguide 106 varies in response to the cross sectional area of the perforations 204. As a result of the variation of the cross sectional area of the perforations 204 depending a location, the height of the ridges 304 also varies as a function of the location in the plate 202. The larger the cross-sectional area of perforations is, the higher the thickness of the ridge 304 of the solid material 200 is at a corresponding location on the waveguide 106. Different solid materials 200 may be deposited to different heights through a same cross-sectional area of perforations, but a person skilled in the art can easily find suitable cross-sectional areas for a desired solid material.

A grating period of the diffractive gratings 100 to 104 i.e. a distance between the ridges 304 and/or grooves 306 may be from about 200nm to about 500nm, for example. A height of the ridges 304 of the diffractive grating 100 to 104 may vary between about 10nm to about 300nm and in some cases about 10 nm to about 1000nm, for example.

The non-zero distance D between the plate 202 and the waveguide 106 makes a flowable state of the solid material 200 distribute over a larger area than the cross-sectional area of the perforations 204 on the waveguide 106 (see Figure 3B). The solid material 200 namely deposits also the under the plate 202 beside a perforation 204. Such a leakage is typically considered undesirable but for the DOE the leakage is advantageous because it allows to form a desired thickness profile of the layer 300 of the solid material 200 and the diffractive gratings 100, 102, 104. Because of the leakage, a height of the layer 300 facing a perforation 204 and a height of the layer 300 facing a solid surface of the plate 202 right beside that perforation 204 has negligible or no difference. That is, the layer 300 may be made so smooth that it does not reveal the positions of the perforations 204 of the plate 202. A profile of the layer 300 may be customized to have multiple higher and lower thickness areas, for example.

The shape of the thickness profile can also be changed by changing the distance D between the waveguide 106 and the plate 202. In an embodiment, the distance D may be different at opposite ends of the plate 202/waveguide 106. Then the height profile will follow more the perforated features at a side where the distance is smaller and the height profile will be more uniform at a side where the distance is larger.

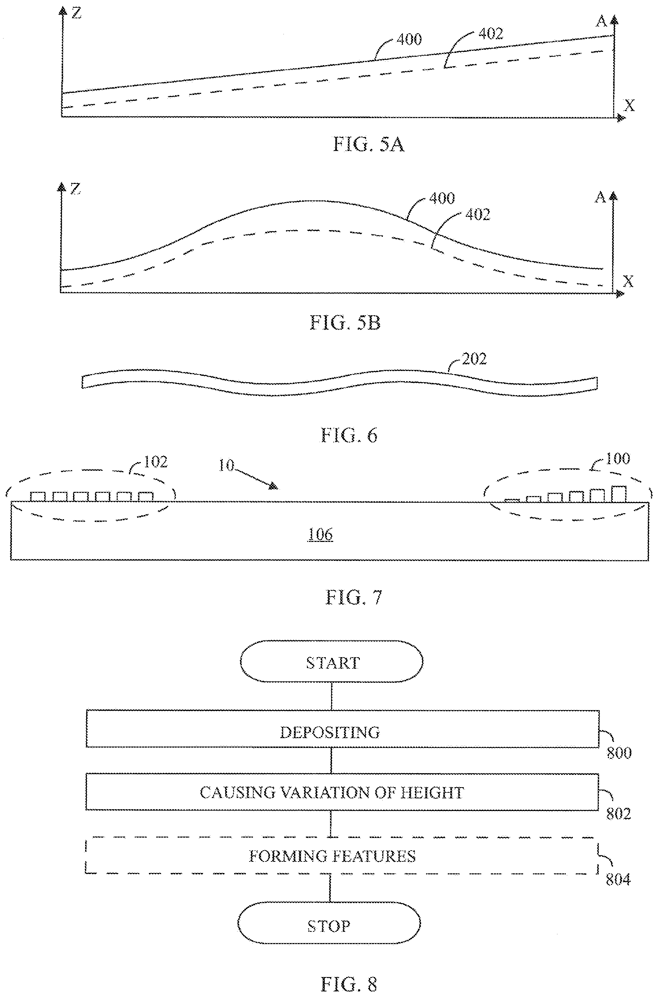

Figure 5A illustrates an example of a distribution 400 of a height of the layer 300 and of the corresponding ridges 304 of the diffraction grating on the waveguide 106 and a distribution 402 of an area of the cross-section of the perforations 204 in the plate 202 in a direction of an X-axis based on examples Figures 3A to 4. The distributions 400 and 402 are linear in this example. The Z-axis at left represents height H and at right area A, and the X-axis represents a location (= distance from origin). All axes are in an arbitrary scale.

Figure 5B illustrates an example of a distribution 400 of a height of the layer 300 and for example ridges 304 on the waveguide 106 and a distribution 402 of an area of the cross-section of the perforations 204 in the plate 202 in a direction of an X-axis. The distributions are not similar in this example, although the distributions may also be similar. The result in Figure 5B may be based on a feature that the perforations 204 are larger in the middle but their density is lower. In this example the distributions 400, 402 resemble a form of a bell curve. The Z-axis at left represents height H and at right area A, and the X-axis represents a location (= distance from origin). All axes are in an arbitrary scale.

According to the present invention and as illustrated in Figure 6, the plate 202 is curved, i.e. a longitudinal profile of the plate 202 is curvy. The curved profile may be wavy, for example. In an embodiment, the plate 202 may be curvy in one dimension only. In an embodiment, the plate 202 may be curvy in two dimensions. In an embodiment, the curviness of the plate 202 may be similar in the two dimensions. In an embodiment, the curviness of the plate 202 may be different in the two dimensions. In these manners, the leakage under the plate 202 beside the perforations 204 may be made in a controllable and desirable manner in different locations of the plate 202/waveguide 106. The curviness may be combined with a variation of the areas of the cross sections of the perforations 204 of the plate 202 such that a variation of the height of the layer 300 may be controlled in a desired manner.

In an embodiment, an antireflection coating may be applied on the diffractive grating 100 to 104.

As can be seen in Figures 4 and 5, it is possible, in an embodiment, to make a diffraction grating 100, 102, 104, which fulfils the following three definitions simultaneously:
1) There are a plurality of pairs of directly successive ridges 304 that fulfill the following features
2) any of said pairs have no solid material 200 therebetween and the ridges 304 of any of said pairs have no solid material 200 therebetween, and
3) the ridges 304 of any pair of said pairs have different heights in a direction along which a height of the ridges 304 is either increasing or decreasing.

For example, at a top of the bell curve of the distribution 400 in Figure 5B there may be a pair of ridges 304 directly adjacent to each other that have the same height. However, it may be possible to make a distribution in an embodiment that there is no pair of ridges 304 directly adjacent to each other on the ascending part the distribution 400 such that the pair has a same height. The same may be made true for the descending part of the distribution 400 in an embodiment.

The lateral size of one DOE can be about 10mm to about 20mm for example and the period of the diffraction grating may be about 400nm for example, with the linear increase/decrease of grating height across the diffraction grating e.g. from about 0nm to about 50nm.

The solid material 200 may be a compound of at least two elements. In an embodiment the solid material may be titanium oxide (TiO₂), for example. The titanium oxide may be amorphous. The refractive index of titanium oxide may be about 2.4 at a wavelength within the visible range. The material 200 should be enough optically transparent for visible light through the thicknesses of the layer 300 depending on the particular type and application of DOE.

Figure 7 illustrates an example where the in-coupling diffraction grating 102 may have constant heights of ridges 304 and the out-coupling diffraction grating 100 may have varying heights of ridges 304.

In an alternative embodiment, it is also possible that the out-coupling diffraction grating 100 may have varying heights of ridges 304 and the in-coupling diffraction grating 102 may have constant heights of ridges 304. Furthermore in an embodiment, both the out-coupling diffraction grating 100 and the in-coupling diffraction grating 102 may have varying heights of ridges 304.

In an embodiment, the out-coupling diffraction grating 100 and the in-coupling diffraction grating 102 may have different variation of heights of ridges 304.

In an embodiment, a variation of heights of ridges 304 of the out-coupling diffraction grating 100 and a variation of heights of ridges 304 of the in-coupling diffraction grating 102 may have a mirror symmetry.

In an embodiment, the out-coupling diffraction grating 100 and the in-coupling diffraction grating 102 may have a similar variation of heights of ridges 304.

A suitable combination of similar or different height distributions between different diffraction gratings 100, 102, 104, where the combination may depend on an application, may improve a quality of the image transferred from the image generating unit 12 to the user's eyes 150, 152 allowing for better image uniformity, better color distributions, and/or a deeper contrast. In these manners, the overall user's experience may be improved. Having a possibility to increase brightness allows the eyewear to be used in different environments such as under bright outdoor lighting conditions. Additionally, when an eyewear device has high optical efficiency, it consumes less electrical power thereby saving battery and/or allowing for a longer operating time.

As explained above, the deposition method comprises the plate 202, which has perforations 204 and a non-zero distance is used between the plate 202 and the waveguide 106. The non-zero distance may be realized with a spacer structure 206. The material 200 penetrates through the perforations 204 in a gaseous state at a rate that depends on a size measurable as cross-sectional area of the perforations 204 at each location. The plate 202 is to be kept at a specific distance from the waveguide 106 in order to achieve a desired thickness modulation across the waveguide 106 and similarly keep conformality of the layer 300 and ridges 304.

What is taught above directly addresses the problem of scattering efficiency modulation in the DOE with at least two significant benefits in comparison to commonly-used methods. First, the performance of the DOE with varying height of grating features can be improved. This is due to controllable changes in the grating height that results in an enhanced modulation of the DOE scattering strength unattainable by solely an in-plane variation of the grating pattern. Second, the manufacturability of such DOE components can substantially outperform the one of alternative widely used methods. In particular, the proposed solution allows to avoid additional deposition steps, additional etching steps, additional lithography steps, use of grayscale lithography, etc. in fabrication of DOEs with periodic features of varying height.

Figure 8 is a flow chart of a manufacturing method of an optical element 10 of an augmented reality eyewear, the optical element 10 comprising a combination of a waveguide 106 for visible light and at least one diffractive grating 100, 102, 104 configured to couple visible light between the waveguide 106 and environment. In step 800, at least one layer 300 of a solid material 200 through perforations 204 of a plate 202 at a non-zero distance D from the waveguide 106 is deposited on the waveguide 106. In step 802, a height of the at least one layer 300 is made to vary in response to cross sectional areas of the perforations 204, the cross sectional areas of the perforations 204 varying based on a location of the perforations 204 in the plate 202 for forming at least one diffractive grating 100, 102, 104 on the waveguide 106 from the at least one layer 300, the at least one diffractive grating 100, 102, 104 being configured to perform in-coupling and/or out-coupling of visible light between the waveguide 106 and environment.

In step 804, which may be performed optionally, ridges 304 of the at least one diffractive grating 100, 102, 104 are formed by removing the solid material 200 from the waveguide 106 at locations of periodical grooves 306 between the ridges 304.

It will be obvious to a person skilled in the art that, as technology advances, the inventive concept can be implemented in various ways. The invention and its embodiments are not limited to the example embodiments described above.

## Claims

1. A manufacturing method of an optical element (10) of an augmented reality eyewear, **characterized by**
depositing (800), on a waveguide (106), at least one layer (300) of a material (200) through perforations (204) of a curved plate (202) at a non-zero distance (D) from the waveguide (106); and
making (802) a height of the at least one layer (300) to vary in response to cross-sectional areas of the perforations (204), which are configured to vary based on a location of the perforations (204) in the curved plate (202) for forming at least one diffractive grating (100, 102, 104) on the waveguide (106) from the at least one layer (300), the at least one diffractive grating (100, 102, 104) being configured to perform in-coupling and/or out-coupling of visible light between the waveguide (106) and environment.

2. The manufacturing method of claim 1, **wherein** the non-zero distance (D) between the curved plate (202) and the waveguide (106) is varied.

3. The manufacturing method of claim 1, **wherein** the material (200) has a refractive index equal to or higher than that of the waveguide (106) in a visible range of light.

4. The manufacturing method of claim 1, **wherein** the depositing (800) is performed by at least one of the following: sputtering, chemical vapor deposition and physical vapor deposition.

5. The manufacturing method of claim 1, **wherein** ridges (304) of the at least one diffractive grating (100, 102, 104) are formed by removing the material (200) from the at least one layer (300) at locations of grooves (306) between the ridges (304).

6. The manufacturing method of claim 1, **wherein** the curved plate (202) is tilted with respect to the waveguide (106).

7. The manufacturing method of claim 1, **wherein** a refractive index of the solid material is higher than 1.8.

8. The manufacturing method of claim 1, **wherein** the cross-sectional areas of the perforations (204) are configured to vary in two dimensions for making the heights of the depositions (300) vary in the two dimensions.

9. An optical component (10), **wherein** the optical component (10) comprises at least one diffractive grating (100 to 104) that is manufactured according to the manufacturing method of claim 1.

10. An apparatus for manufacturing an optical component (10), **wherein**
the apparatus comprises a curved plate (202) with perforations (204), each of the perforations (204) having a cross sectional area depending on its location in the curved plate (202), the curved plate (202) and a waveguide (106) of the optical component (10) being configured to have a non-zero distance therebetween; and
the apparatus is configured to deposit, on the waveguide (106), at least one layer (300) of solid material (200) through the perforations (204) of the curved plate (202) for causing a height of the layer (300) on the waveguide (106) to vary in response to the cross-sectional areas of the perforations (204).

11. The apparatus of claim 10, **wherein** the apparatus is configured to allow the distance (D) between the curved plate (202) and the waveguide (106) to vary.

12. The apparatus of claim 10, **wherein** the plate (202) is tilted and curved with respect to the waveguide (106).

13. The apparatus of claim 10, **wherein** the apparatus has an adjusting means (210) configured to adjust the distance (D) between the curved plate (202) and the waveguide (106) based on the cross-sectional areas of the perforations (204).

14. The apparatus of claim 10, **wherein** the apparatus is configured to remove the solid material (200) from locations for gaps (306) between ridges (304) of at least one diffractive grating (100, 102, 104) and keep the solid material (200) at locations of the ridges (304) of the at least one diffractive grating (100, 102, 104).

## Patentansprüche

1. Herstellungsverfahren für ein optisches Element (10) einer Augmented Reality Brille, **gekennzeichnet durch**:
Aufbringen (800) mindestens einer Schicht (300) eines Materials (200) auf einen Wellenleiter (106) durch Perforationen (204) einer gebogenen Platte (202) in einem Abstand ungleich Null (D) vom Wellenleiter (106); und
Erzeugen einer Höhe (802) der mindestens einen Schicht (300), um in Abhängigkeit von den Querschnittsflächen der Perforationen (204) zu variieren, die wiederum so konfiguriert sind, dass sie basierend auf den Positionen der Perforationen (204) in der gebogenen Platte (202) variieren, um aus der mindestens einen Schicht (300) mindestens ein Beugungsgitter (100, 102, 104) auf dem Wellenleiter (106) zu bilden, wobei das mindestens eine Beugungsgitter (100, 102, 104) so konfiguriert ist, dass es eine Einkopplung und/oder Auskopplung von sichtbarem Licht zwischen dem Wellenleiter (106) und der Umgebung ermöglicht.

2. Herstellungsverfahren nach Anspruch 1, wobei der Abstand ungleich Null (D) zwischen der gebogenen Platte (202) und dem Wellenleiter (106) variiert wird.

3. Herstellungsverfahren nach Anspruch 1, wobei das Material (200) im sichtbaren Lichtbereich einen Brechungsindex aufweist, der gleich oder höher als der des Wellenleiters (106) ist.

4. Herstellungsverfahren nach Anspruch 1, wobei die Abscheidung (800) durch mindestens eines der folgenden Verfahren erfolgt: Sputtern, chemische Gasphasenabscheidung und physikalische Gasphasenabscheidung.

5. Herstellungsverfahren nach Anspruch 1, wobei Stege (304) des mindestens einen Beugungsgitters (100, 102, 104) durch Entfernen des festen Materials (200) aus der mindestens einen Schicht (300) an Stellen von Nuten (306) zwischen den Stegen (304) gebildet werden.

6. Herstellungsverfahren nach Anspruch 1, wobei die gebogene Platte (202) gegenüber dem Wellenleiter (106) geneigt ist.

7. Herstellungsverfahren nach Anspruch 1, wobei der Brechungsindex des festen Materials größer als 1,8 ist.

8. Herstellungsverfahren nach Anspruch 1, wobei die Querschnittsflächen der Perforationen (204) so konfiguriert sind, dass sie in zwei Dimensionen variieren, um die Höhen der Ablagerungen (300) in zwei Dimensionen variieren zu lassen.

9. Optische Komponente (10), wobei die optische Komponente (10) mindestens ein Beugungsgitter (100 bis 104) umfasst, das nach dem Herstellungsverfahren von Anspruch 1 hergestellt ist.

10. Vorrichtung zur Herstellung einer optischen Komponente (10), wobei
die Vorrichtung eine gebogene Platte (202) mit Perforationen (204) umfasst, wobei jede der Perforationen (204) eine Querschnittsfläche aufweist, die von ihrer Position in der gebogenen Platte (202) abhängt, wobei die gebogene Platte (202) und ein Wellenleiter (106) der optischen Komponente (10) so konfiguriert sind, dass sie einen Abstand ungleich Null zueinander aufweisen; und
die Vorrichtung so konfiguriert ist, dass sie auf dem Wellenleiter (106) mindestens eine Schicht (300) aus festem Material (200) durch die Perforationen (204) der Platte (202) abscheidet, sodass eine Höhe der Schicht (300) auf dem Wellenleiter (106) in Abhängigkeit von den Querschnittsflächen der Perforationen (204) erzeugt wird.

11. Vorrichtung nach Anspruch 10, wobei die Vorrichtung so konfiguriert ist, dass der Abstand (D) zwischen der gebogenen Platte (202) und dem Wellenleiter (106) variiert werden kann.

12. Vorrichtung nach Anspruch 10, wobei die Platte (202) gegenüber dem Wellenleiter (106) geneigt und gekrümmt ist.

13. Vorrichtung nach Anspruch 10, wobei die Vorrichtung eine Einstelleinrichtung (210) aufweist, die so konfiguriert ist, dass sie den Abstand (D) zwischen der gebogenen Platte (202) und dem Wellenleiter (106) auf der Grundlage der Querschnittsflächen der Perforationen (204) einstellt.

14. Vorrichtung nach Anspruch 10, wobei die Vorrichtung so konfiguriert ist, dass sie das feste Material (200) von Stellen für Lücken (306) zwischen den Stegen (304) des mindestens einen Beugungsgitters (100, 102, 104) entfernt und das feste Material (200) an Stellen der Stege (304) des mindestens einen Beugungsgitters (100, 102, 104) zurückhält.

## Revendications

1. Procédé de fabrication d'un élément optique (10) de lunettes à réalité augmentée, **caractérisé par**
la déposition (800), sur un guide d'ondes (106), d'au moins une couche (300) d'une matière (200) à travers des perforations (204) d'une plaque incurvée (202) à une distance non nulle (D) du guide d'ondes (106), et
le fait de faire varier (802) une hauteur de l'au moins une couche (300) en fonction de superficies de section transversale des perforations (204) qui sont configurées pour varier en fonction d'un emplacement des perforations (204) dans la plaque incurvée (202) afin de former au moins un réseau de diffraction (100, 102, 104) sur le guide d'ondes (106) à partir de l'au moins une couche (300), l'au moins un réseau de diffraction (100, 102, 104) étant configuré pour réaliser un couplage d'entrée et/ou un découplage de lumière visible entre le guide d'ondes (106) et l'environnement.

2. Procédé de fabrication selon la revendication 1, dans lequel la distance non nulle (D) entre la plaque incurvée (202) et le guide d'ondes (106) peut varier.

3. Procédé de fabrication selon la revendication 1, dans lequel la matière (200) a un indice de réfraction supérieur ou égal à celui du guide d'ondes (106) dans une gamme de lumière visible.

4. Procédé de fabrication selon la revendication 1, dans lequel la déposition (800) est réalisée par au moins un des processus suivants : une pulvérisation cathodique, une déposition chimique en phase vapeur et une déposition physique en phase vapeur.

5. Procédé de fabrication selon la revendication 1, dans lequel des nervures (304) de l'au moins un réseau de diffraction (100, 102, 104) sont formées en retirant de la matière (200) de l'au moins une couche (300) à des emplacements de rainures (306) entre les nervures (304).

6. Procédé de fabrication selon la revendication 1, dans lequel la plaque incurvée (202) est inclinée par rapport au guide d'ondes (106).

7. Procédé de fabrication selon la revendication 1, dans lequel un indice de réfraction de la matière solide est supérieur à 1,8.

8. Procédé de fabrication selon la revendication 1, dans lequel les superficies de section transversale des perforations (204) sont configurées pour varier en deux dimensions afin de faire varier les hauteurs des dépositions (300) dans les deux dimensions.

9. Composant optique (10), dans lequel le composant optique (10) comprend au moins un réseau de diffraction (100 à 104) qui est fabriqué selon le procédé de fabrication selon la revendication 1.

10. Dispositif de fabrication d'un composant optique (10), dans lequel :
le dispositif comprend une plaque incurvée (202) comprenant des perforations (204),
chacune des perforations (204) ayant une superficie de section transversale dépendant de son emplacement dans la plaque incurvée (202), la plaque incurvée (202) et un guide d'ondes (106) du composant optique (10) étant disposés de façon à ménager une distance non nulle entre eux, et
le dispositif est configuré pour déposer, sur le guide d'ondes (106), au moins une couche (300) de matière solide (200) à travers les perforations (204) de la plaque incurvée (202) de manière à faire varier une hauteur de la couche (300) sur le guide d'ondes (106) en fonction des superficies de section transversale des perforations (204).

11. Dispositif selon la revendication 10, dans lequel le dispositif est configuré pour permettre de faire varier la distance (D) entre la plaque incurvée (202) et le guide d'ondes (106).

12. Dispositif selon la revendication 10, dans lequel la plaque (202) est inclinée et incurvée par rapport au guide d'ondes (106).

13. Dispositif selon la revendication 10, dans lequel le dispositif comprend des moyens de réglage (210) configurés pour ajuster la distance (D) entre la plaque incurvée (202) et le guide d'ondes (106) en fonction des surfaces de section transversale des perforations (204).

14. Dispositif selon la revendication 10, dans lequel le dispositif est configuré pour retirer de la matière solide (200) d'emplacements d'interstices (306) entre des nervures (304) d'au moins un réseau de diffraction (100, 102, 104) et pour maintenir la matière solide (200) aux emplacements des nervures (304) de l'au moins un réseau de diffraction (100, 102, 104).
